(19) Europäisches Patentamt / European Patent Office / Office européen des brevets

(11) **EP 3 819 352 A1**

(12) **EUROPEAN PATENT APPLICATION**
published in accordance with Art. 153(4) EPC


(43) Date of publication:
**12.05.2021 Bulletin 2021/19**

(21) Application number: **19829862.2**

(22) Date of filing: **01.07.2019**

(51) Int Cl.:
***C09K 3/14*** *(2006.01)* ***B24B 37/00*** *(2012.01)*
***C09G 1/02*** *(2006.01)* ***H01L 21/304*** *(2006.01)*

(86) International application number:
**PCT/JP2019/026040**

(87) International publication number:
**WO 2020/009054 (09.01.2020 Gazette 2020/02)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
**KH MA MD TN**

(30) Priority: **04.07.2018 JP 2018127239**



(71) Applicant: **Sumitomo Seika Chemicals Co., Ltd.**
**Kako-gun, Hyogo 675-0145 (JP)**

(72) Inventors:
- **MASUDA, Tsuyoshi**
  **Himeji-shi, Hyogo 672-8076 (JP)**
- **NISHIGUCHI, Hideaki**
  **Kako-gun, Hyogo 675-0145 (JP)**

(74) Representative: **Vossius & Partner Patentanwälte Rechtsanwälte mbB**
**Siebertstrasse 3**
**81675 München (DE)**


(54) **POLISHING COMPOSITION**


(57) Provided is a polishing means that can improve the flatness of a substrate without significantly reducing the polishing speed. More specifically, provided is a polishing composition comprising inorganic particles, water, and a modified polyalkylene oxide represented by formula (1):

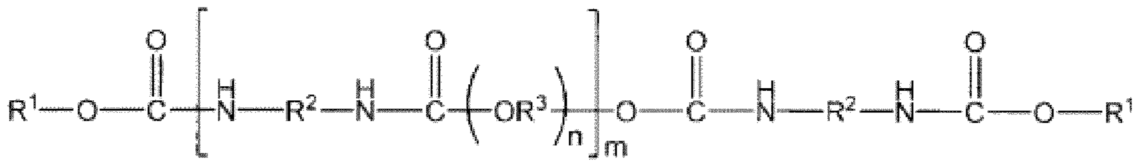

(1)

wherein
$R^1$ are each independently a group represented by $R^{11}$-$(OR^{12})_x$-, wherein $R^{11}$ are each independently a $C_{1-24}$ alkyl group, $R^{12}$ are each independently a $C_{2-4}$ alkylene group, and x is an integer of 0 to 500,
$R^2$ are each independently a hydrocarbon group,
$R^3$ are each independently a $C_{2-4}$ alkylene group,
n is an integer of 1 to 1000, and
m is an integer of 1 or more.


EP 3 819 352 A1

Fig. 1

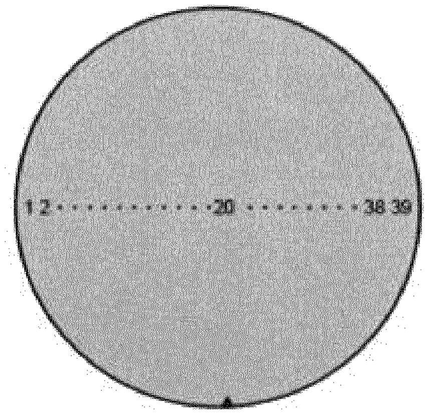


Measurement points

## Description

### Technical Field

The present disclosure relates to a polishing composition and the like.

### Background Art

In the mirror processing of semiconductor wafers etc. used as base materials for forming integrated circuits, chemical mechanical polishing (hereinafter also referred to as "CMP") is generally used. This is a method of having a polishing slurry containing silica-based or ceria-based inorganic abrasive grains flow between a polishing cloth or a polishing pad and an object to be polished, such as a semiconductor wafer, and chemically and mechanically polishing the object.

Polishing by CMP requires surface smoothing, high polishing speed, and the like. In particular, with the miniaturization of semiconductor devices or the higher integration of integrated circuits, higher levels of reduction in surface defects and flatness are required for substrates, such as semiconductor wafers.

In order to reduce surface defects and achieve higher flatness, it has been proposed to polish the substrate surface with a polishing composition containing a water-soluble polymer. For example, proposals have been made for a polishing composition comprising a water-soluble polymer having a molecular weight of 100,000 or more (PTL 1), and a polishing composition comprising a cellulose derivative or polyvinyl alcohol (PTL 2). However, in order to improve the flatness of the substrate, it is necessary to reduce the polishing speed, which has caused the problem of polishing efficiency dropping.

### Citation List

### Patent Literature

PTL 1: JPH02-158684A
PTL 2: JPH11-116942A
PTL 3: WO2014/007366

### Summary of Invention

### Technical Problem

The present inventors intended to provide a polishing composition that can improve the flatness of a substrate without significantly reducing the polishing speed, by using a specific modified polyalkylene for polishing.

### Solution to Problem

The present inventors found the possibility that the surface roughness of a substrate could be preferably reduced by polishing the substrate using a composition comprising inorganic particles, water, and a specific modified polyalkylene oxide, and made further improvements.

The present disclosure includes, for example, the subjects described in the following items.

Item 1.
A polishing composition (preferably a polishing composition for a substrate forming an integrated circuit) comprising:

inorganic particles,
water, and
a modified polyalkylene oxide represented by formula (1) :

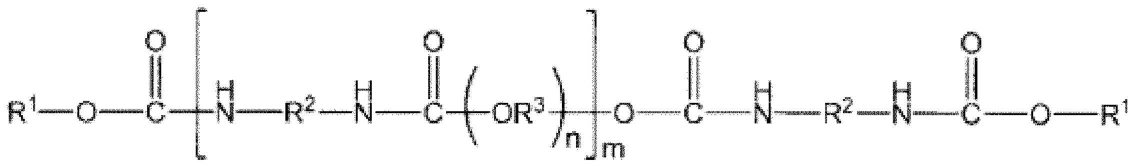

(1)

wherein

$R^1$ are each independently a group represented by $R^{11}$-$(OR^{12})_x$-, wherein $R^{11}$ are each independently a $C_{1-24}$ alkyl group, $R^{12}$ are each independently a $C_{2-4}$ alkylene group, and x is an integer of 0 to 500,
$R^2$ are each independently a hydrocarbon group,
$R^3$ are each independently a $C_{2-4}$ alkylene group,
n is an integer of 1 to 1000, and
m is an integer of 1 or more.

Item 2.
The composition according to Item 1, wherein in formula (1), $R^2$ are each independently a methyl diphenylene group, a hexamethylene group, a methyl dicyclohexylene group, a 3-methyl-3,5,5-trimethyl cyclohexylene group, a dimethyl phenylene group, or a tolylene group.

Item 3.
The composition according to Item 1 or 2, wherein in formula (1), x is an integer of 0 to 30.

Item 4.
The composition according to any one of Items 1 to 3, wherein in formula (1), n is an integer of 100 to 700.

Item 5.
The composition according to any one of Items 1 to 4, wherein in formula (1), m is an integer of 1 to 10.

Item 6.
The composition according to Item 1, wherein in formula (1),
$R^2$ are each independently a methyl diphenylene group, a hexamethylene group, a methyl dicyclohexylene group, a 3-methyl-3,5,5-trimethyl cyclohexylene group, a dimethyl phenylene group, or a tolylene group,
x is an integer of 0 to 30,
n is an integer of 100 to 700, and
m is an integer of 1 to 10.

Item 7.
The composition according to any one of Items 1 to 6, wherein the inorganic particles are at least one member selected from the group consisting of transition metal oxides, aluminum oxide, silica, titanium oxide, silicon carbide, and diamond.

Item 8.
A polishing aid (preferably a polishing aid for a substrate forming an integrated circuit) comprising a modified polyalkylene oxide represented by formula (1):

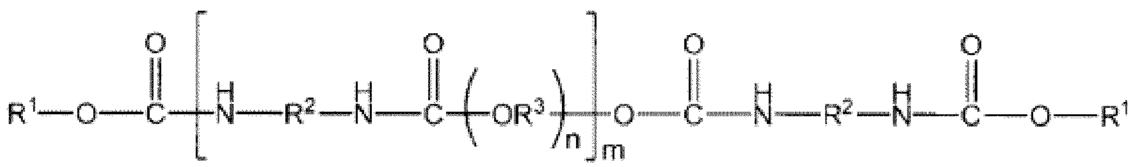

(1)

wherein

$R^1$ are each independently a group represented by $R^{11}$-$(OR^{12})_x$-, wherein $R^{11}$ are each independently a $C_{1-24}$ alkyl group, $R^{12}$ are each independently a $C_{2-4}$ alkylene group, and x is an integer of 0 to 500,
$R^2$ are each independently a hydrocarbon group,
$R^3$ are each independently a $C_{2-4}$ alkylene group,
n is an integer of 1 to 1000, and
m is an integer of 1 or more.

Advantageous Effects of Invention

A polishing means that can improve the flatness of a substrate without significantly reducing the polishing speed is provided.

Brief Description of Drawing

Fig. 1 shows measurement points (39 points) for measuring the amount of polishing, polishing speed, and flatness when a substrate is polished.

Description of Embodiments

Embodiments included in the present disclosure will be described in more detail below. The present disclosure preferably includes a polishing composition, a method for producing the same, a polishing aid, and the like, but is not limited thereto. The present disclosure includes everything disclosed in the present specification and recognizable to those skilled in the art.
The polishing composition included in the present disclosure comprises inorganic particles, water, and a specific modified polyalkylene oxide. Hereinafter, this polishing composition is also referred to as "the polishing composition of the present disclosure."
The specific polyalkylene oxide is a modified polyalkylene oxide represented by formula (1):

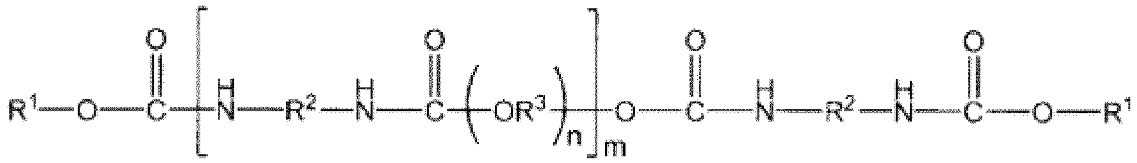

(1)

wherein

$R^1$ are each independently a group represented by $R^{11}$-$(OR^{12})_x$-, wherein $R^{11}$ are each independently a $C_{1-24}$ alkyl group, $R^{12}$ are each independently a $C_{2-4}$ alkylene group, and x are each independently an integer of 0 to 500,
$R^2$ are each independently a hydrocarbon group,
$R^3$ are each independently a $C_{2-4}$ alkylene group,
n is an integer of 1 to 1000, and
m is an integer of 1 or more.

$R^1$ are each independently (i.e., the same or different) a group represented by $R^{11}$- $(O-R^{12})_x$-.
$R^{11}$ are each independently (i.e., the same or different) a $C_{1-24}$ (1, 2, 3, 4, 5, 6, 7, 8, 9, 10, 11, 12, 13, 14, 15, 16, 17, 18, 19, 20, 21, 22, 23, or 24) alkyl group, and preferably a $C_{8-24}$ alkyl group. The alkyl group may be linear or branched, preferably linear.
$R^{12}$ are each independently a $C_{2-4}$ (2, 3, or 4) alkylene group. The alkylene group may be linear or branched, preferably linear. The number of $R^{12}$ is 2x, and as described above, $R^{12}$ are independent from each other, and may be the same or different.
Further, x are each independently an integer of 0 to 500, and preferably an integer of 0 to 100. That is, x is preferably 1, 2, 3, 4, 5, 6, 7, 8, 9, 10, 11, 12, 13, 14, 15, 16, 17, 18, 19, 20, 21, 22, 23, 24, 25, 26, 27, 28, 29, 30, 31, 32, 33, 34, 35, 36, 37, 38, 39, 40, 41, 42, 43, 44, 45, 46, 47, 48, 49, 50, 51, 52, 53, 54, 55, 56, 57, 58, 59, 60, 61, 62, 63,

64, 65, 66, 67, 68, 69, 70, 71, 72, 73, 74, 75, 76, 77, 78, 79, 80, 81, 82, 83, 84, 85, 86, 87, 88, 89, 90, 91, 92, 93, 94, 95, 96, 97, 98, 99, or 100. This modified polyalkylene oxide has two $R^1$. If these are different, x may also be different. In other words, in the modified polyalkylene oxide, when one of two $R^1$ is $R^{1a}$, and the other one is $R^{1b}$, and when $R^{1a}$ is a group represented by $R^{11a}$-(O-$R^{12a}$)$_{xa}$-, and $R^{1b}$ is a group represented by $R^{11b}$-(O-$R^{12b}$)$_{xb}$-, xa and xb may be different. In addition, as described above, $R^{11a}$ and $R^{11b}$ may be different, and $R^{12a}$ and $R^{12b}$ may be different.

$R^2$ are each independently a hydrocarbon group. Specific examples of the hydrocarbon group include a methyl diphenylene group, a hexamethylene group, a methyl dicyclohexylene group, a 3-methyl-3,5,5-trimethyl cyclohexylene group, a dimethyl phenylene group, and a tolylene group. The number of $R^2$ is (m+1), and as described above, $R^{12}$ are independent from each other, and may be the same or different.

$R^3$ are each independently a $C_{2-4}$ (2, 3, or 4) alkylene group. The alkylene group may be linear or branched, preferably linear. The number of $R^3$ is m·n, and as described above, $R^3$ are independent from each other, and may be the same or different. That is, in the modified polyalkylene oxide (formula (1)), the number of units represented by [-NH-$R^2$-NH-CO-($OR^3$)$_n$-] is m, and m number of units may be the same or different. Further, each unit has n number of ($OR^3$), and n number of ($OR^3$) may be the same or different. In addition, each unit has n number of $R^2$, and n number of $R^2$ may be the same or different, as described above.

n is an integer of 1 to 1000. The lower limit of this range may be, for example, 10, 20, 30, 40, 50, 60, 70, 80, 90, 100, 110, 120, 130, 140, or 150. The upper limit of this range may be, for example, 950, 900, 850, 800, 750, 700, or 650. Further, for example, n may be an integer of 50 to 900, 80 to 800, 100 to 750, 120 to 700, or 130 to 680.

m is an integer of 1 or more. For example, m may be 1, 2, 3, 4, 5, 6, 7, 8, 9, 10, 11, 12, 13, 14, 15, 16, 17, 18, 19, or 20. m is preferably an integer of 1 to 10, 1 to 8, 1 to 6, 1 to 5, or 1 to 4.

The modified polyalkylene oxides can be used singly or in combination of two or more.

A preferable example of the modified polyalkylene oxide is a modified polyalkylene oxide obtained by reacting a specific polyalkylene oxide compound (A), a specific polyether monoalcohol (B), and a specific diisocyanate compound (C). Hereinafter, this modified polyalkylene oxide as a preferable example is also referred to as "modified polyalkylene oxide P." Further, hereinafter, these components are also simply referred to as (A), (B), or (C).

Regarding modified polyalkylene oxide P, (A) is a polyethylene oxide represented by formula (II):

$$HO\text{-}(CH_2CH_2O)_n\text{-}H \qquad (II)$$

wherein n is as defined above.

Although it is not particularly limited, the number average molecular weight of the polyethylene oxide is preferably about 6,000 to 30,000, and more preferably about 11,000 to 20,000.

The number average molecular weight of polyethylene oxide (A) is determined by the following formula from the hydroxyl value $O_1$ obtained by Method A of JIS K 1557-1:2007 (Plastics-Polyols for use in the production of polyurethane - Part 1: Determination of hydroxyl number). That is, with both ends of the polyethylene oxide as hydroxyl groups, the number average molecular weight thereof can be determined by the following formula:

$$\text{Number average molecular weight} = (56{,}100\times2)/O_1$$

(B) is a polyether monoalcohol having a structure of a random copolymer of ethylene oxide (EO) and propylene oxide (PO), one end of which is an OH group and the other end of which is a group represented by $R^{11}$ ($R^{11}$ is as defined above). Alternatively, (B) is an alkyl alcohol represented by $R^{11}$-OH. This alkyl alcohol can be interpreted as a compound in the state of no copolymer of EO and PO in the above polyether monoalcohol.

Hereinafter, among the groups represented by $R^{11}$, a $C_{15-24}$ linear alkyl group is also referred to as $R^{11z}$. Further, although it is not particularly limited, when the number of moles of ethylene oxide added is a, and the number of moles of propylene oxide added is b, the ratio (a/b) thereof is preferably in the range of 1 to 2. a and b are both 0 or positive numbers, and satisfy a + b = x. Moreover, as long as this condition is satisfied, a and b can take the values that x can take.

The polyether monoalcohol can also be regarded as polyoxyethylene polyoxypropylene monoalkyl ether having randomly copolymerized ethylene oxide and propylene oxide (the ratio of the numbers of moles added (a/b) being preferably 1 to 2, and more preferably 1.1 to 1.5), and having an alkyl group represented by $R^{11}$ (preferably an alkyl group represented by $R^{11z}$) . The case in which (B) is an alkyl alcohol represented by $R^{11}$-OH can also be interpreted to mean that in the above monoalcohol, a and b are both 0 (i.e., x = 0).

(B) can be particularly preferably represented by the following formula (III):

$$R^{11}\text{-}[(OCH_2CH_2)_a\text{-ran-}(OCH_2CH(CH_3))_b]\text{-}OH \qquad (III)$$

$R^{11}$ in the formula is more preferably $R^{11z}$, for example. As described above, a and b are both 0 or positive numbers, and satisfy a + b = x. When a = b = 0, formula (III) represents $R^{11}$-OH.

Here, $[(OCH_2CH_2)_a$-ran- $(OCH_2CH(CH_3))_b]$ indicates that the structural units $(OCH_2CH_2)$and $(OCH_2CH(CH_3))$ are randomly copolymerized. It is also indicated that the degrees of polymerization of the structural units are a and b. As can be understood from this, "ran" in the expression $[\alpha_i$-ran-$\beta_j]$ means that structural units $\alpha$ and $\beta$ are randomly copolymerized at degrees of polymerization i and j, respectively.

The ratio (a/b) in (B) is not particularly limited, as described above, but is preferably 1 to 2, and more preferably 1.1 to 1.5.

Although there is no limitation as long as the effect of the polishing composition of the present disclosure is not impaired, a is preferably an integer of 5 to 10, for example. Further, b is preferably an integer of 5 to 8, for example. It is more preferable that a is an integer of 5 to 10 and b is an integer of 5 to 8.

$R^{11z}$ is, as described above, a $C_{15-24}$ linear alkyl group, preferably a $C_{16-22}$ linear alkyl group, and more preferably a $C_{16-20}$ linear alkyl group.

(B) has a structure in which a random copolymer of propylene oxide and ethylene oxide (polyalkylene oxide) is added to a linear monohydric saturated alcohol.

The random copolymer of propylene oxide and ethylene oxide here may be a block copolymer of propylene oxide and ethylene oxide; however, a random copolymer is preferable.

(B) can be obtained, for example, by addition polymerization of ethylene oxide and propylene oxide to an alkyl alcohol represented by $R^{11}$-OH (preferably a linear monohydric saturated alcohol). The alkyl alcohol represented by $R^{11}$-OH is a $C_{1-24}$ (preferably $C_{15-24}$, more preferably $C_{16-22}$, and even more preferably $C_{16-20}$) linear saturated alcohol.

A general method can be used as the method for addition polymerization of ethylene oxide and propylene oxide to an alkyl alcohol represented by $R^{11}$-OH. For example, the addition polymerization can be carried out by radical polymerization using a polymer initiator containing a peroxide or an azo group, or by using a polymer chain transfer agent in which a thiol group or the like that easily causes a chain transfer reaction is introduced.

The number average molecular weight of (B) is preferably 800 to 3,000, and more preferably 1,000 to 2,500, although it is not particularly limited as long as the effect of the polishing composition of the present disclosure is exhibited.

The number average molecular weight of (B) is determined by the following formula from the hydroxyl value $O_1$ obtained by Method A of JIS K 1557-1:2007 (Plastics-Polyols for use in the production of polyurethane - Part 1: Determination of hydroxyl number). That is, with one end of the polyethylene oxide as a hydroxyl group, the number average molecular weight thereof can be determined by the following formula:

$$\text{Number average molecular weight} = (56{,}100)/O_1$$

The amount of (B) used is preferably 1 to 2 mol, more preferably 1.1 to 2 mol, and even more preferably 1.5 to 2 mol, per mol of (A), although it is not particularly limited as long as the effect of the polishing composition of the present disclosure is exhibited.

(C) is a diisocyanate compound represented by formula (IV) :

$$O=C=N\text{-}R^2\text{-}N=C=O \qquad \text{(IV)}$$

$R^2$ is as defined above, and is preferably a methyl diphenylene group, a hexamethylene group, a methyl dicyclohexylene group, a 3-methyl-3,5,5-trimethyl cyclohexylene group, a dimethyl phenylene group, or a tolylene group, as described above.

Specific examples of (C) include 4,4'-diphenylmethane diisocyanate (MDI), 1,6-hexamethylene diisocyanate (HDI), dicyclohexylmethane-4,4'-diisocyanate (HMDI), 3-isocyanatomethyl-3,5,5-trimethylcyclohexyl isocyanate (IPDI), 1,8-dimethylbenzol-2,4-diisocyanate, 2,4-tolylene diisocyanate (TDI), and the like. Among these diisocyanate compounds, dicyclohexylmethane-4,4'-diisocyanate (HMDI) and 1,6-hexamethylene diisocyanate (HDI) are preferable, from the viewpoint of the excellent weather resistance and transparency of the obtained modified polyalkylene oxide. These diisocyanate compounds may be used singly or in combination of two or more.

Regarding the ratio of the diisocyanate compound used, when the total number of moles of terminal hydroxyl groups in (A) and (B) (the number of moles of [-OH]) is 1, the number of moles of isocyanate groups (the number of moles of [-NCO]) in the isocyanate compound is preferably 0.8 to 1.2, and more preferably 0.9 to 1.1. That is, the number of moles of isocyanate groups in the isocyanate compound is preferably 0.8 to 1.2 mol, and more preferably 0.9 to 1.1 mol, per mol of all the terminal hydroxyl groups in (A) and (B).

Modified polyalkylene oxide P is obtained by reacting (A), (B), and (C), as described above, and a compound represented by the following formula (I) is considered to be the main component thereof.

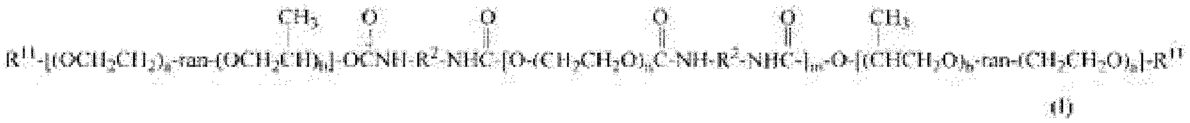

(I)

In formula (I), $R^{11}$, $R^2$, a, b, $[(OCH_2CH_2)_a\text{-ran-}(OCH_2CH(CH_3))_b]$, m, and n are as defined above.

Examples of the method of reacting polyalkylene oxide compound (A), polyether monoalcohol (B), and diisocyanate compound (C) include a method in which they are dissolved or dispersed in a reaction solvent, such as toluene, xylene, or dimethylformamide, and then reacted; and a method in which solids are crushed into powder or melted into a liquid form, and they are mixed uniformly, and then reacted by heating to a predetermined temperature. From the viewpoint of industrial implementation, preferable is a method in which the raw materials are continuously supplied in a heated and molten state to a multi-screw extruder, in which they are and mixed and reacted. The temperature of the reaction is preferably 70 to 210°C, more preferably 90 to 180°C, and even more preferably 100 to 160°C. The reaction time can be appropriately set so that the reaction is completed, depending on the reaction temperature, the types of polyalkylene oxide compound, polyether monoalcohol, and diisocyanate compound used, and the like. The reaction time refers to the average residence time in the multi-screw extruder determined in the following manner. The average residence time is measured by supplying a small amount of colorant (e.g., crushed red chalk or blue No. 5) to the multi-screw extruder simultaneously with a polyalkylene oxide compound, a polyether monoalcohol, and a diisocyanate compound, observing the change in the color of the discharged material, and measuring the time when the darkest color part is discharged. The average residence time is adjusted to 0.5 to 5.0 minutes, preferably 1.0 to 3.5 minutes, and more preferably 1.5 to 3.0 minutes, by the supply amount, rotation speed, and screw shape.

Moreover, when modified polyalkylene oxide P is produced, a small amount of a reaction accelerator, such as triethylamine, triethanolamine, dibutyltin diacetate, dibutyltin dilaurate, stannous octoate, or triethylenediamine, can be added to the reaction system, from the viewpoint of accelerating the reaction. The amount of the reaction accelerator used is preferably 200 to 2,000 mass ppm, and more preferably 500 to 1,000 mass ppm, based on the polyalkylene oxide compound.

Thus, modified polyalkylene oxide P can be obtained by mixing and reacting a polyalkylene oxide compound, a polyether monoalcohol, and a diisocyanate compound in a suitable reactor, such as an extruder. The resulting modified polyalkylene oxide P is mainly obtained as a mixture of compounds of general formula (I) wherein m = about 1 to 4, in which the polyalkylene oxide compound and the diisocyanate compound are repeatedly polymerized. These can be used without separation. The ratio thereof can be confirmed by separation by GPC etc. In particular, a compound wherein m = 1 or 2 is the main product.

A modified polyalkylene oxide represented by formula (1) other than modified polyalkylene oxide P can also be produced based on the above description.

As the inorganic particles, those known as inorganic abrasive grains for polishing can be preferably used. Specific examples include transition metal oxides, aluminum oxide, silica, titanium oxide, silicon carbide, diamond, and the like. In particular, silica and transition metal oxides are preferable. More specifically, the silica is preferably, for example, colloidal silica, fumed silica, precipitated silica, or the like. The transition metal is preferably cerium oxide, zirconium oxide, iron oxide, or the like; and particularly preferably cerium oxide. The inorganic particles can be used singly or in combination of two or more.

The average particle size of these inorganic particles is preferably 2 μm or less, and more preferably 1.5 μm or less, 1 μm or less, 0.5 μm or less, 0.3 μm or less, 0.2 μm or less, or 0.1 μm or less. The average particle size of the inorganic particles is the particle size at an integrated value of 50% in the particle size distribution measured by a laser diffraction scattering method using water as a solvent.

Although it is not particularly limited, the polishing composition of the present disclosure is preferably in the form of a slurry (in the present specification, the polishing composition in the form of a slurry is also particularly referred to as a "polishing slurry"). The polishing composition (particularly polishing slurry) of the present disclosure can be prepared, for example, by mixing inorganic particles, water, and the specific modified polyalkylene oxide mentioned above.

In the polishing composition of the present disclosure, the content mass ratio of the modified polyalkylene oxide and the inorganic particles (modified polyalkylene oxide:inorganic particles) is not particularly limited as long as the effect is exhibited, but is, for example, preferably about 1:100 to 1000, and more preferably about 1:200 to 800, about 1:300 to 700, or about 1:400 to 600.

Further, for example, in the polishing composition of the present disclosure, the modified polyalkylene oxide is preferably contained in an amount of about 0.01 to 2 mass%, more preferably about 0.02 to 1 mass%, and even more preferably about 0.05 to 0.75 mass%.

To the extent that the effect is not impaired, the polishing composition of the present disclosure may further contain various additives known in the art. Examples of such known additives include surfactants, organic polyanionic

substances, chelating agents, pH regulators, and the like. Examples of surfactants include sodium alkylbenzene sulfonate, formalin condensates of naphthalene sulfonic acid, and the like. Examples of organic polyanionic substances include lignin sulfonate, polyacrylate, and the like. Examples of chelating agents include dimethylglyoxime, dithizone, oxine, acetylacetone, glycine, EDTA, NTA, and the like. Examples of pH regulators include bases and acids. Examples of bases include sodium hydroxide, potassium hydroxide, ammonium hydroxide, tetramethylammonium hydroxide (TMAH), ammonia, choline compounds (e.g., choline hydroxide), and the like. Examples of acids include hydrochloric acid, sulfuric acid, phosphoric acid, nitric acid, and the like. Of these, potassium hydroxide is preferable as the base, and sulfuric acid is preferable as the acid. Such known additives can be used singly or in combination of two or more.

The polishing composition of the present disclosure can be preferably used, for example, for polishing the surface of a substrate for forming an integrated circuit (e.g., a semiconductor wafer such as a silicon wafer; the wafer may have an oxide film), and the surface roughness of the substrate can be further reduced.

The present disclosure also includes a polishing aid comprising the specific modified polyalkylene oxide. The polishing aid can be combined, for example, with inorganic particles and water to form a polishing composition, and can be preferably used for polishing the surface of a substrate or the like for forming an integrated circuit. For inorganic particles, the above explanation applies as is. Moreover, when preparing a polishing composition, the above explanation also applies as is to the amounts or ratios of the specific polyalkylene oxide, inorganic particles, and water to be contained in the polishing aid. The polishing aid may be the specific modified polyalkylene oxide itself, or may contain other components as long as the effect is not impaired. Examples of such other components include water and the known additives mentioned above for the polishing composition.

In the present specification, the term "comprising" includes "consisting essentially of" and "consisting of." Further, the present disclosure includes all of any combinations of the constituent requirements described in the present specification.

In addition, the various characteristics (properties, structures, functions, etc.) described in each embodiment of the present disclosure described above may be combined in any way in specifying the subjects included in the present disclosure. In other words, the present disclosure includes all the subjects comprising all combinations of the combinable characteristics described in the present specification.

## Examples

The subjects of the present disclosure will be described in more detail below; however, the subjects of the present disclosure are not limited to the following examples.

### Polishing property evaluation method

A polishing pad (IC1400 K-XY Grv, produced by Nitta Haas Inc.) was set in a polishing apparatus (RDP-500, produced by Fujikoshi Machinery Corp.). Using a diamond dresser (#100, produced by Asahi Diamond Industrial Co., Ltd.), the polishing pad surface was ground at 8.5 kgf and a dresser rotation speed of 100 rotations/minute for 10 minutes. Next, while the polishing slurry produced in each of the Examples or Comparative Examples was supplied at a speed of 150 ml/min under the conditions of a platen rotation speed of 90 rpm, a head rotation speed of 90 rpm, a polishing pressure of 280 g/cm$^2$, and a polishing time of 60 seconds, a silicon wafer having an oxide film surface (1000 nm) with a diameter of 8 inches was polished.

The polishing properties of each polishing slurry were evaluated by evaluating the polishing speed during polishing and the surface roughness of the silicon wafer surface after polishing. The polishing speed and surface roughness were evaluated by the following methods.

### Polishing speed

The film thickness of the oxide film on the silicon wafer surface before and after polishing was measured with a noncontact optical film thickness meter (Nanospec 5100, produced by Nanometrics) to determine the amount of polishing. The amount of polishing was measured at 39 points (see Fig. 1) on the silicon wafer, and their average value was used as the polishing speed. The standard deviation of the measurement results was regarded as the flatness.

### Surface roughness

The surface roughness of the oxide film on the silicon wafer surface 20 (the center point of polishing amount measurement points 1 to 39) before and after polishing was measured by AFM (AFM5400L, produced by Hitachi High-Tech Science Corporation).

Measurement of median particle size and molecular weight of modified polyalkylene oxide

The median particle size was determined by a dry sieving method (JIS Z8815). Specifically, 50 g of resin was weighed, sieved using a JIS standard sieve (JIS Z8801), and then weighed for each sieve. Based on the results, the particle size at the point where the integrated mass was 50% was determined.

In addition, 0.5 g of modified polyalkylene oxide was dissolved by heating in 49.5 g of DMF, and its molecular weight (in terms of PEO) and distribution were determined by GPC as shown below. "PEO" is an abbreviation for polyethylene oxide, and "in terms of PEO" means that a calibration curve was created using PEOs each with a known molecular weight as a molecular weight marker of GPC, and the calibration curve was used to determine the molecular weight of the modified polyalkylene oxide.

Carrier: DMF (LiBr 0.1 mmol/L)
Column: three columns of TOSOH TSK gel Multipore HxL-M (exclusion limit 2000000: polystyrene)
Pump flow rate: 0.6 mL/min

Production Example 1

In storage tank A equipped with a stirrer kept at 80°C, 100 parts by mass of sufficiently dehydrated polyethylene oxide with a number average molecular weight of 8,000, 3 parts by mass of decyl alcohol $CH_3$-$(CH_2)_9$-OH, and 0.1 parts by mass of dioctyl tin laurate were supplied and stirred under a nitrogen gas atmosphere to obtain a uniform mixture.

Separately, dicyclohexylmethane-4,4'-diisocyanate was placed in storage tank B kept at 30°C, and stored under a nitrogen gas atmosphere.

Using a metering pump, the mixture in storage tank A at a speed of 200 [g/min] and the dicyclohexylmethane-4,4'-diisocyanate in storage tank B at a speed of 16 [g/min] were continuously supplied to a twin-screw extruder (L/D = 40) with a screw outer diameter of 26 mm set at 110 to 140°C. They were mixed and reacted in the extruder, and a strand was discharged from the extruder outlet, and pelletized by a pelletizer to obtain a modified polyalkylene oxide.

According to the GPC measurement, the obtained modified polyalkylene oxide was a mixture of compounds of formula (I) wherein approximately m = 1 to 5, the number average molecular weight was $2.4 \times 10^4$, and the weight average molecular weight was $4.0 \times 10^4$.

The obtained modified polyalkylene oxide was immersed in liquid nitrogen, then pulverized to a median particle size of about 250 μm, and subjected to the evaluation.

Production Example 2

In storage tank A equipped with a stirrer kept at 80°C, 100 parts by mass of sufficiently dehydrated polyethylene oxide with a number average molecular weight of 20,000, 7.4 parts by mass of polyether stearyl alcohol $CH_3$ $(CH_2)_{17}$O-[$(CH_2CH_2O)_8$-ran-$(CH_2CH(CH_3)O)_6$]-H (Blaunon SA50/50, produced by Aoki Oil Industrial Co., Ltd., number average molecular weight: 1,000), and 0.2 parts by mass of dioctyl tin laurate were supplied and stirred under a nitrogen gas atmosphere to obtain a uniform mixture.

Separately, dicyclohexylmethane-4,4'-diisocyanate was placed in storage tank B kept at 30°C, and stored under a nitrogen gas atmosphere.

Using a metering pump, the mixture in storage tank A at a speed of 200 [g/min] and the dicyclohexylmethane-4,4'-diisocyanate in storage tank B at a speed of 4.24 [g/min] were continuously supplied to a twin-screw extruder (L/D = 40) with a screw outer diameter of 26 mm set at 110 to 140°C. They were mixed and reacted in the extruder, and a strand was discharged from the extruder outlet, and pelletized by a pelletizer to obtain a modified polyalkylene oxide.

According to the GPC measurement, the obtained modified polyalkylene oxide was a mixture of compounds of formula (I) approximately with 55% of m = 1, 25% of m = 2, 15% of m = 3, and 5% of m = 4 (a trace amount of m = 5), and the number average molecular weight thereof was 36,700. The obtained modified polyalkylene oxide was immersed in liquid nitrogen, then pulverized to a median particle size of about 250 pm, and subjected to the evaluation.

Production Example 3

In storage tank A equipped with a stirrer kept at 80°C, 100 parts by mass of sufficiently dehydrated polyethylene oxide with a number average molecular weight of 20,000, 3 parts by mass of polyoxyethylene lauryl ether $CH_3$-$(CH_2)_{11}$-$(OCH_2CH_2)_n$-HO (n = 5, 12, or 20), and 0.1 parts by mass of dioctyl tin laurate were supplied and stirred under a nitrogen gas atmosphere to obtain a uniform mixture.

Separately, dicyclohexylmethane-4,4'-diisocyanate was placed in storage tank B kept at 30°C, and stored under

a nitrogen gas atmosphere.

Using a metering pump, the mixture in storage tank A at a speed of 200 [g/min] and the dicyclohexylmethane-4,4'-diisocyanate in storage tank B at a speed of 6 [g/min] were continuously supplied to a twin-screw extruder (L/D = 40) with a screw outer diameter of 26 mm set at 110 to 140°C. They were mixed and reacted in the extruder, and a strand was discharged from the extruder outlet, and pelletized by a pelletizer to obtain a modified polyalkylene oxide.

The obtained modified polyalkylene oxide was immersed in liquid nitrogen, and then pulverized to a median particle size of about 250 μm.

Production Example 4

In storage tank A equipped with a stirrer kept at 80°C, 100 parts by mass of sufficiently dehydrated polyethylene oxide with a number average molecular weight of 20,000, 3 parts by mass of stearyl alcohol $CH_3$-$(CH_2)_{17}$-HO, and 0.1 parts by mass of dioctyl tin laurate were supplied and stirred under a nitrogen gas atmosphere to obtain a uniform mixture.

Separately, dicyclohexylmethane-4,4'-diisocyanate was placed in storage tank B kept at 30°C, and stored under a nitrogen gas atmosphere.

Using a metering pump, the mixture in storage tank A at a speed of 200 [g/min] and the dicyclohexylmethane-4,4'-diisocyanate in storage tank B at a speed of 8 [g/min] were continuously supplied to a twin-screw extruder (L/D = 40) with a screw outer diameter of 26 mm set at 110 to 140°C. They were mixed and reacted in the extruder, and a strand was discharged from the extruder outlet, and pelletized by a pelletizer to obtain a modified polyalkylene oxide.

The obtained modified polyalkylene oxide was immersed in liquid nitrogen, and then pulverized to a median particle size of about 250 pm.

Production Example 5

In storage tank A equipped with a stirrer kept at 80°C, 100 parts by mass of sufficiently dehydrated polyethylene oxide with a number average molecular weight of 11,000, 14.0 parts by mass of polyether stearyl alcohol $CH_3(CH_2)_{17}O$-$[(CH_2CH_2O)_8$-ran-$(CH_2CH(CH_3)O)_6]$-H (Blaunon SA50/50, produced by Aoki Oil Industrial Co., Ltd., number average molecular weight: 1,000), and 0.2 parts by mass of dioctyl tin laurate were supplied and stirred under a nitrogen gas atmosphere to obtain a uniform mixture.

Separately, 1,6-hexamethylene diisocyanate was placed in storage tank B kept at 30°C, and stored under a nitrogen gas atmosphere.

Using a metering pump, the mixture in storage tank A at a speed of 250 [g/min] and the 1,6-hexamethylene diisocyanate in storage tank B at a speed of 5.93 [g/min] were continuously supplied to a twin-screw extruder (L/D = 40) with a screw outer diameter of 26 mm set at 110 to 140°C. They were mixed and reacted in the extruder, and a strand was discharged from the extruder outlet, and pelletized by a pelletizer to obtain a modified polyalkylene oxide. According to the GPC measurement, the obtained modified polyalkylene oxide was a mixture of compounds of formula (I) approximately with 60% of m = 1, 25% of m = 2, 10% of m = 3, and 5% of m = 4, and the number average molecular weight thereof was 20,000. The obtained pellets were immersed in liquid nitrogen, and then pulverized to a median particle size of about 100 μm.

Production Example 6

In storage tank A equipped with a stirrer kept at 80°C, 100 parts by mass of sufficiently dehydrated polyethylene oxide with a number average molecular weight of 20,000, 8.3 parts by mass of polyether cetyl alcohol $CH_3(CH_2)_{15}O$-$[(CH_2CH_2O)_{10}$-ran-$(CH_2CH(CH_3O)_8]$-H (UniSafe 10P-8, produced by NOF Corporation, number average molecular weight: 1,150), and 0.2 parts by mass of dioctyl tin laurate were supplied and stirred under a nitrogen gas atmosphere to obtain a uniform mixture.

Separately, dicyclohexylmethane-4,4'-diisocyanate was placed in storage tank B kept at 30°C, and stored under a nitrogen gas atmosphere.

Using a metering pump, the mixture in storage tank A at a speed of 220 [g/min] and the dicyclohexylmethane-4,4'-diisocyanate in storage tank B at a speed of 4.59 [g/min] were continuously supplied to a twin-screw extruder (L/D = 40) with a screw outer diameter of 26 mm set at 110 to 140°C. They were mixed and reacted in the extruder, and a strand was discharged from the extruder outlet, and pelletized by a pelletizer to obtain a modified polyalkylene oxide. According to the GPC measurement, the obtained modified polyalkylene oxide was a mixture of compounds of formula (I) approximately with 55% of m = 1, 20% of m = 2, 15% of m = 3, and 10% of m = 4, and the number average molecular weight thereof was 39,000. The obtained pellets were immersed in liquid nitrogen, and then pulverized to a median particle size of about 100 pm.

Production Example 7

In storage tank A equipped with a stirrer kept at 80°C, 100 parts by mass of sufficiently dehydrated polyethylene oxide with a number average molecular weight of 20,000, 6.7 parts by mass of polyether stearyl alcohol $CH_3(CH_2)_{17}O-[(CH_2CH_2O)_4-ran-(CH_2CH(CH_3)O)_7]-H$ (Blaunon SA30/70, produced by Aoki Oil Industrial Co., Ltd., number average molecular weight: 900), and 0.2 parts by mass of dioctyl tin laurate were supplied and stirred under a nitrogen gas atmosphere to obtain a uniform mixture.

Separately, dicyclohexylmethane-4,4'-diisocyanate was placed in storage tank B kept at 30°C, and stored under a nitrogen gas atmosphere.

Using a metering pump, the mixture in storage tank A at a speed of 200 [g/min] and the dicyclohexylmethane-4,4'-diisocyanate in storage tank B at a speed of 4.29 [g/min] were continuously supplied to a twin-screw extruder (L/D = 40) with a screw outer diameter of 26 mm set at 110 to 140°C. They were mixed and reacted in the extruder, and a strand was discharged from the extruder outlet, and pelletized by a pelletizer to obtain a modified polyalkylene oxide. According to the GPC measurement, the obtained modified polyalkylene oxide was a mixture of compounds of formula (I) approximately with 55% of m = 1, 30% of m = 2, 10% of m = 3, and 5% of m = 4, and the number average molecular weight thereof was 35,500. The obtained pellets were immersed in liquid nitrogen, and then pulverized to a median particle size of about 100 μm.

Production Example 8

In storage tank A equipped with a stirrer kept at 80°C, 100 parts by mass of sufficiently dehydrated polyethylene oxide with a number average molecular weight of 11,000, 13.6 parts by mass of polyether behenyl alcohol $CH_3(CH_2)_{21}O-[(CH_2CH_2O)_{15}-ran-(CH_2CH(CH_3)O)_1]-H$ (Pepole BEP-0115, produced by TOHO Chemical Industry Co., Ltd., number average molecular weight: 1,040), and 0.2 parts by mass of dioctyl tin laurate were supplied and stirred under a nitrogen gas atmosphere to obtain a uniform mixture.

Separately, 1,6-hexamethylene diisocyanate was placed in storage tank B kept at 30°C, and stored under a nitrogen gas atmosphere.

Using a metering pump, the mixture in storage tank A at a speed of 250 [g/min] and the 1,6-hexamethylene diisocyanate in storage tank B at a speed of 5.78 [g/min] were continuously supplied to a twin-screw extruder (L/D = 40) with a screw outer diameter of 26 mm set at 110 to 140°C. They were mixed and reacted in the extruder, and a strand was discharged from the extruder outlet, and pelletized by a pelletizer to obtain a modified polyalkylene oxide. According to the GPC measurement, the obtained modified polyalkylene oxide was a mixture of compounds of formula (I) approximately with 50% of m = 1, 35% of m = 2, 10% of m = 3, and 5% of m = 4, and the number average molecular weight thereof was 21,200. The obtained pellets were immersed in liquid nitrogen, and then pulverized to a median particle size of about 100 μm.

Production Example 9

In storage tank A equipped with a stirrer kept at 80°C, 100 parts by mass of sufficiently dehydrated polyethylene oxide with a number average molecular weight of 20,000, 3.2 parts by mass of polyether stearyl ether $C_{18}H_{37}O-(CH_2CH_2O)_{20}-H$ (Nonion S-220, produced by NOF Corporation, molecular weight: 1,150), and 0.2 parts by mass of dioctyl tin laurate were supplied and stirred under a nitrogen gas atmosphere to obtain a uniform mixture.

Separately, dicyclohexylmethane-4,4'-diisocyanate was placed in storage tank B kept at 30°C, and stored under a nitrogen gas atmosphere.

Using a metering pump, the mixture in storage tank A at a speed of 250 [g/min] and the dicyclohexylmethane-4,4'-diisocyanate in storage tank B at a speed of 2.43 [g/min] were continuously supplied to a twin-screw extruder (L/D = 40) with a screw outer diameter of 26 mm set at 110 to 140°C. They were mixed and reacted in the extruder, and a strand was discharged from the extruder outlet, and pelletized by a pelletizer to obtain a modified polyalkylene oxide. According to the GPC measurement, the obtained modified polyalkylene oxide was a mixture of compounds of formula (I) approximately with 55% of m = 1, 15% of m = 2, 25% of m = 3, and 5% of m = 4, and the number average molecular weight thereof was 31,100. The obtained pellets were immersed in liquid nitrogen, and then pulverized to a median particle size of about 100 μm.

Production Example 10

In storage tank A equipped with a stirrer kept at 80°C, 100 parts by mass of sufficiently dehydrated polyethylene oxide with a number average molecular weight of 4,000, 36.0 parts by mass of polyether stearyl alcohol $CH_3(CH_2)_{17}O-[(CH_2CH_2O)_8-ran-(CH_2CH(CH_3)O)_6]-H$ (Blaunon SA50/50, produced by Aoki Oil Industrial Co., Ltd., number

average molecular weight: 1,000), and 0.2 parts by mass of dioctyl tin laurate were supplied and stirred under a nitrogen gas atmosphere to obtain a uniform mixture.

Separately, dicyclohexylmethane-4,4'-diisocyanate was placed in storage tank B kept at 30°C, and stored under a nitrogen gas atmosphere.

Using a metering pump, the mixture in storage tank A at a speed of 200 [g/min] and the dicyclohexylmethane-4,4'-diisocyanate in storage tank B at a speed of 16.57 [g/min] were continuously supplied to a twin-screw extruder (L/D = 40) with a screw outer diameter of 26 mm set at 110 to 140°C. They were mixed and reacted in the extruder, and a strand was discharged from the extruder outlet, and pelletized by a pelletizer to obtain a modified polyalkylene oxide. According to the GPC measurement, the obtained modified polyalkylene oxide was a mixture of compounds of formula (I) approximately with 50% of m = 1, 35% of m = 2, 10% of m = 3, and 5% of m = 4, and the number average molecular weight thereof was 9,500. The obtained pellets were immersed in liquid nitrogen, and then pulverized to a median particle size of about 100 $\mu$m.

Example 1

To 1 kg of 0.05% aqueous solution of the modified polyalkylene oxide obtained in Production Example 1, 1 kg of Slurry SS25 (produced by Cabot Corporation, composed of 25 mass% of fumed silica (average particle size: 0.16 $\mu$m) and pure water) prepared at a pH of 10.7 was added and mixed to obtain a polishing slurry. Using this polishing slurry, the polishing properties were evaluated by the above method. The percentage indicating the concentration of the modified polyalkylene oxide aqueous solution is mass (wt/wt)% (the same applies hereinafter).

Example 2

A polishing slurry was prepared in the same manner as in Example 1, except that the aqueous solution concentration of the modified polyalkylene oxide obtained in Production Example 1 was changed to 0.1%. Then, the polishing properties were evaluated.

Example 3

A polishing slurry was prepared in the same manner as in Example 1, except that the aqueous solution concentration of the modified polyalkylene oxide obtained in Production Example 1 was changed to 0.6%. Then, the polishing properties were evaluated.

Example 4

A polishing slurry was prepared in the same manner as in Example 1, except that the aqueous solution concentration of the modified polyalkylene oxide obtained in Production Example 1 was changed to 1%. Then, the polishing properties were evaluated.

Example 5

A polishing slurry was prepared in the same manner as in Example 1, except that the aqueous solution of the modified polyalkylene oxide was changed to 1 kg of 0.1% aqueous solution of the modified polyalkylene oxide obtained in Production Example 2. Then, the polishing properties were evaluated.

Example 6

A polishing slurry was prepared in the same manner as in Example 5, except that the aqueous solution concentration of the modified polyalkylene oxide obtained in Production Example 2 was changed to 0.6%. Then, the polishing properties were evaluated.

Comparative Example 1

A polishing slurry was prepared in the same manner as in Example 1, except that the modified polyalkylene oxide aqueous solution was changed to pure water. Then, the polishing properties were evaluated.

Comparative Example 2

A polishing slurry was prepared in the same manner as in Example 1, except that the modified polyalkylene oxide aqueous solution was changed to a 0.6 mass% carboxymethyl cellulose (Cellogen F-AG, produced by DKS Co. Ltd.) aqueous solution. Then, the polishing properties were evaluated.

Table 1 summarizes the polishing property evaluation results.

Table 1

| Polishing slurry | Resin added | Resin content (mass%) | Polishing speed (nm/min) | Flatness | Surface roughness Ra (nm) |
|---|---|---|---|---|---|
| Example 1 | Production Example 1 | 0.025 | 178 | 35 | 0.199 |
| Example 2 | | 0.05 | 188 | 31 | 0.191 |
| Example 3 | | 0.3 | 174 | 31 | 0.191 |
| Example 4 | | 0.5 | 173 | 27 | 0.196 |
| Example 5 | Production Example 2 | 0.05 | 181 | 27 | 0.209 |
| Example 6 | | 0.3 | 159 | 24 | 0.181 |
| Comparative Example 1 | None | - | 241 | 36 | 0.175 |
| Comparative Example 2 | CMC | 0.3 | 227 | 49 | 0.177 |
| "Ra" indicates the arithmetic average roughness. | | | | | |

## Claims

**1.** A polishing composition comprising:

inorganic particles,
water, and
a modified polyalkylene oxide represented by formula (1) :

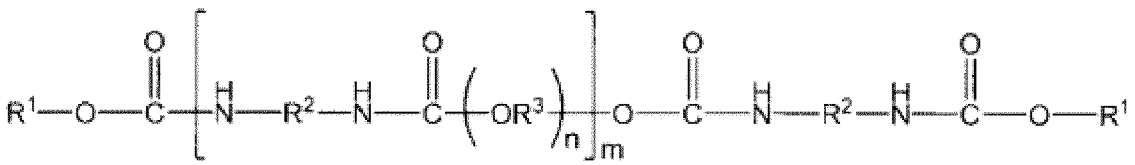

(1)

wherein

$R^1$ are each independently a group represented by $R^{11}$-$(OR^{12})_x$-, wherein $R^{11}$ are each independently a $C_{1-24}$ alkyl group, $R^{12}$ are each independently a $C_{2-4}$ alkylene group, and x is an integer of 0 to 500,
$R^2$ are each independently a hydrocarbon group,
$R^3$ are each independently a $C_{2-4}$ alkylene group,
n is an integer of 1 to 1000, and
m is an integer of 1 or more.

**2.** The composition according to claim 1, wherein in formula (1), $R^2$ are each independently a methyl diphenylene group, a hexamethylene group, a methyl dicyclohexylene group, a 3-methyl-3,5,5-trimethyl cyclohexylene group, a dimethyl phenylene group, or a tolylene group.

**3.** The composition according to claim 1 or 2, wherein in formula (1), x is an integer of 0 to 30.

**4.** The composition according to any one of claims 1 to 3, wherein in formula (1), n is an integer of 100 to 700.

**5.** The composition according to any one of claims 1 to 4, wherein in formula (1), m is an integer of 1 to 10.

**6.** The composition according to claim 1, wherein in formula (1),
$R^2$ are each independently a methyl diphenylene group, a hexamethylene group, a methyl dicyclohexylene group, a 3-methyl-3,5,5-trimethyl cyclohexylene group, a dimethyl phenylene group, or a tolylene group,
x is an integer of 0 to 30,
n is an integer of 100 to 700, and
m is an integer of 1 to 10.

**7.** The composition according to any one of claims 1 to 6, wherein the inorganic particles are at least one member selected from the group consisting of transition metal oxides, aluminum oxide, silica, titanium oxide, silicon carbide, and diamond.

**8.** A polishing aid comprising a modified polyalkylene oxide represented by formula (1):

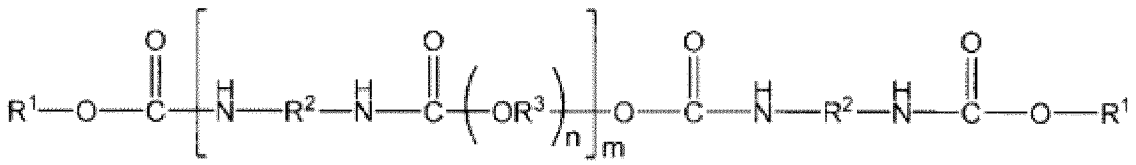

(1)

wherein

$R^1$ are each independently a group represented by $R^{11}$-$(OR^{12})_x$-, wherein $R^{11}$ are each independently a $C_{1-24}$ alkyl group, $R^{12}$ are each independently a $C_{2-4}$ alkylene group, and x is an integer of 0 to 500,
$R^2$ are each independently a hydrocarbon group,
$R^3$ are each independently a $C_{2-4}$ alkylene group,
n is an integer of 1 to 1000, and
m is an integer of 1 or more.

Fig. 1

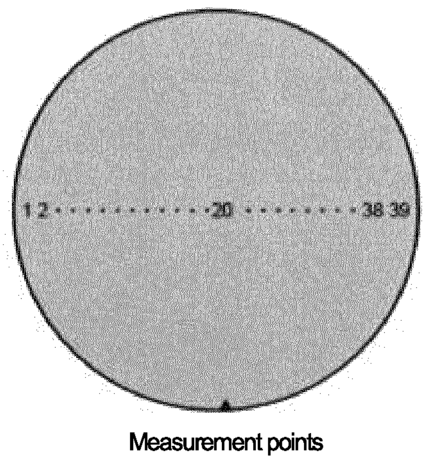

## INTERNATIONAL SEARCH REPORT

International application No. PCT/JP2019/026040

A. CLASSIFICATION OF SUBJECT MATTER
Int.Cl. C09K3/14(2006.01)i, B24B37/00(2012.01)i, C09G1/02(2006.01)i, H01L21/304(2006.01)i
According to International Patent Classification (IPC) or to both national classification and IPC

B. FIELDS SEARCHED
Minimum documentation searched (classification system followed by classification symbols)
Int.Cl. C09K3/14, B24B37/00, C09G1/02, H01L21/304

Documentation searched other than minimum documentation to the extent that such documents are included in the fields searched

| | |
|---|---|
| Published examined utility model applications of Japan | 1922-1996 |
| Published unexamined utility model applications of Japan | 1971-2019 |
| Registered utility model specifications of Japan | 1996-2019 |
| Published registered utility model applications of Japan | 1994-2019 |

Electronic data base consulted during the international search (name of data base and, where practicable, search terms used)
CAplus/REGISTRY (STN)

C. DOCUMENTS CONSIDERED TO BE RELEVANT

| Category* | Citation of document, with indication, where appropriate, of the relevant passages | Relevant to claim No. |
|---|---|---|
| A | JP 2013-541194 A (CABOT MICROELECTRONICS CORPORATION) 07 November 2013, paragraph [0064] & US 2012/0058642 A1, paragraph [0069] & WO 2012/030752 A2 & EP 2611878 A2 & CN 103097486 A & KR 10-2013-0103519 A | 1-8 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| | |
|---|---|
| Date of the actual completion of the international search<br>22 August 2019 (22.08.2019) | Date of mailing of the international search report<br>03 September 2019 (03.09.2019) |
| Name and mailing address of the ISA/<br>Japan Patent Office<br>3-4-3, Kasumigaseki, Chiyoda-ku,<br>Tokyo 100-8915, Japan | Authorized officer<br><br>Telephone No. |

Form PCT/ISA/210 (second sheet) (January 2015)

**INTERNATIONAL SEARCH REPORT**

International application No. PCT/JP2019/026040

C (Continuation). DOCUMENTS CONSIDERED TO BE RELEVANT

| Category* | Citation of document, with indication, where appropriate, of the relevant passages | Relevant to claim No. |
|---|---|---|
| A | JP 2013-140984 A (CHEIL INDUSTRIES INC.) 18 July 2013, claims & US 2013/0171823 A1, claims & KR 10-2013-0078605 A & CN 103184011 A | 1-8 |
| A | JP 2003-342556 A (FUJIMI INCORPORATED) 03 December 2003, claims & GB 2390370 A, claims & CN 1461766 A | 1-8 |
| A | WO 2014/007366 A1 (SUMITOMO SEIKA CHEMICALS CO., LTD.) 09 January 2014, claims, examples & US 2015/0183920 A1, claims, examples & EP 2871193 A1 & CA 2878312 A & KR 10-2015-0036175 A | 1-8 |

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP H02158684 A
- JP H11116942 A
- WO 2014007366 A